# DEMANDE DE BREVET EUROPEEN

(11) **EP 2 330 738 A1**
(43) Date de publication de la demande: **08.06.2011**
(21) Numéro de dépôt: 09177918.1
(22) Date de dépôt: 03.12.2009
(51) Int. Cl.: H03H 9/02, H03H 9/24

(54) **Résonateur MEMS à transistor et oscillateur comportant un tel résonateur**

(71) Demandeur: ETA SA Manufacture Horlogère Suisse, 2540 Grenchen (CH)
(72) Inventeur: Ionescu, Adrian Mihai, 1024 Ecublens (CH); Grogg, Daniel, 1024 Ecublens (CH); Ayöz, Suat, 1814 La Tour-de-Peilz (CH)
(74) Mandataire: Surmely, Gérard

(57) **Abrégé**

Le résonateur MEMS à transistor comprend :
- un caisson dans lequel est formé un élément de conduction constitué par une région de source (308), une région de drain (309), et une région semi-conductrice formant un canal reliant la région de source et la région de drain ;
- une structure vibrante (310) solidaire d'un substrat tout en étant libre de vibrer ;
- une structure fixe (330) portée par le substrat, un espace (ou gap) étant aménagé entre la structure fixe et la structure vibrante ;

le caisson étant intégré soit dans la structure vibrante, soit dans la structure fixe (330), de telle façon que le canal s'étende en regard du dit espace, et ledit espace renferme une microstructure (328) en un matériau piézoélectrique prévue pour assurer un couplage électromécanique entre la structure vibrante (310) et le canal de manière à permettre de moduler la conductibilité de l'élément de conduction à la fréquence de vibration de la structure vibrante.

## Description

### Domaine de l'invention

La présente invention concerne les résonateurs MEMS à transistor et les oscillateurs MEMS comportant de tels résonateurs MEMS à transistor. La présente invention concerne plus particulièrement les oscillateurs comportant un transistor à grille résonante, et notamment de tels oscillateurs utilisés comme base de temps.

### Etat de la technique

Les oscillateurs qui utilisent la résonance d'un résonateur électromécanique pour produire un signal d'une fréquence déterminée sont le plus souvent formés d'un circuit oscillant intégré, et d'un résonateur à couplage piézoélectrique qui n'est pas lui-même intégré avec le circuit. On comprendra que cette construction augmente de façon indésirable la dimension et le coût de tels dispositifs. Un certain nombre de solutions ont donc été proposées pour fournir des oscillateurs à résonateur qui soient entièrement intégrés.

Le document de brevet US 3,413,573 notamment décrit un oscillateur comportant un résonateur électromécanique et pouvant en principe être entièrement réalisé à l'aide des techniques usuelles de fabrication de circuit intégrés. L'oscillateur proposé est construit autour d'un résonateur à transistor, plus spécifiquement autour d'un transistor à grille résonante. Un transistor à grille résonante est constitué par l'association d'un transistor à commande par potentiel de surface et d'un résonateur disposé en regard du transistor et prévu pour produire un champ électrique oscillant à la surface du transistor. À titre d'exemple, le transistor à commande par potentiel de surface peut être un transistor à effet de champ (FET) réalisé dans un substrat semi-conducteur. Le résonateur, quant à lui, est constitué par une poutre flexible encastrée, qui est réalisée en un matériau conducteur. La poutre flexible s'étend au dessus du substrat dans lequel est formé le transistor, et elle est prévue pour vibrer sous l'effet d'une excitation électrostatique.

L'extrémité libre de la poutre se déplace en regard du transistor FET de manière à permettre aux vibrations de la poutre de commander le transistor. A cet effet, la poutre est polarisée avec une tension constante relativement au substrat dans lequel est formé le transistor. La tension de polarisation doit être suffisamment élevée pour que le champ électrique émanant de l'extrémité de la poutre influence la conductibilité du transistor à effet de champ. Lorsque cette condition est remplie et que l'extrémité de la poutre oscille, s'écartant et se rapprochant alternativement du transistor, l'intensité fluctuante du champ électrique à la surface du transistor a pour effet de moduler la conductibilité de ce dernier ; d'où l'appellation de transistor « à grille résonante ».

Le résonateur à transistor, dont le principe de fonctionnement vient d'être décrit, présente certains inconvénients. En particulier, seul une très petite fraction du champ électrique autour de la poutre flexible agit sur le transistor FET. La tension de polarisation de la poutre flexible doit donc être relativement élevée ; voir même plus élevée que la tension maximale supportée par les circuits intégrés habituels. D'autre part, le couplage électromécanique n'étant pas optimal, la résistance dynamique (en anglais; « motional résistance ») du résonateur s'en trouve augmentée.

Le document de brevet WO 2007/135'064 intitulé « dispositif sensible au mouvement comportant au moins un transistor » décrit plusieurs variantes de résonateurs MEMS à transistor utilisant une pluralité de transistors pour un couplage électromécanique amélioré. Ce document enseigne par ailleurs qu'au lieu de réaliser le transistor à commande par potentiel de surface dans le substrat, et de faire jouer à la structure vibrante le rôle de grille, on peut de manière équivalente intégrer le corps du transistor à la structure vibrante et prévoir une grille fixe, de manière à ce que le corps du transistor soit mobile en regard de la grille.

Un but de la présente invention est donc de fournir un oscillateur MEMS comportant un transistor à grille résonnante qui présente un couplage électromécanique amélioré indépendamment du nombre de transistors et qui présente également une consommation d'énergie réduite.

La figure 5 du document de brevet US 4,873,871 illustre un accéléromètre fonctionnant grâce à un transistor à grille mécanique (MFET). La figure 1 annexée reproduit la figure 5 de ce document antérieur. Le MFET (référencé 10') comprend un substrat 12' et une grille 52. Le substrat 12' comprend un drain 20', une source 22', une couche d'oxyde 24' et une pluralité de connecteurs 46'. Enfin, le substrat 12' comprend encore une zone 44' située entre la source et le drain et dans laquelle une concentration ou une déplétion de porteurs de charge est susceptible de se produire.

La grille 52 comprend un matériau piézoélectrique 54 ainsi qu'une masse sismique 56. Lorsqu'une force d'inertie perpendiculaire au substrat agit sur la masse sismique, le matériau piézoélectrique 54 et soit comprimé soit étiré, ce qui a pour effet de polariser le matériau piézoélectrique 54. Le champ électrique associé à cette polarisation fait varier la concentration de porteurs de charge dans la zone 44'. En particulier, lorsque le matériau piézoélectrique 54 est comprimé, des électrons sont attirés vers la surface de la zone 44' donnant naissance à un canal à travers lequel un courant électrique peut circuler entre le drain 20' et la source 22'. Comme le champ électrique engendré par la compression du matériau piézoélectrique est suffisant pour faire changer la concentration de porteurs de charge dans la zone 44', la grille 52 n'a pas besoin d'être connectée à une source de tension externe. On comprendra que le transistor décrit dans ce document antérieur est conçu pour remplir la fonction de transducteur électromécanique et qu'il ne s'agit absolument pas d'un transistor à grille résonante.

### Bref exposé de l'invention

Un but de la présente invention est de palier aux inconvénients susmentionnés de l'art antérieur. La présente invention atteint ce but en fournissant un résonateur MEMS à transistor conforme à la revendication 1.

Selon un premier mode de réalisation de l'invention, le caisson comprenant la région de source, la région de drain et le canal reliant la région de source et la région de drain, est intégré dans la structure fixe. Selon une première variante de ce mode de réalisation, la microstructure en un matériau piézoélectrique est solidaire de la structure vibrante et séparée du canal par un espace. Selon une variante alternative de ce mode de réalisation, la microstructure en un matériau piézoélectrique est solidaire à la fois de la structure vibrante et de la structure fixe.

Selon un deuxième mode de réalisation de la présente invention, le caisson est intégré dans la structure vibrante. Selon une variante de ce mode de réalisation, la microstructure en un matériau piézoélectrique est solidaire à la fois de la structure vibrante et de la structure fixe.

La présente invention a également pour objet un oscillateur MEMS conforme à la revendication 11.

On comprendra que l'oscillateur MEMS selon la présente invention est réalisé autour d'un résonateur à transistor selon la présente invention. Un avantage lié à l'utilisation du résonateur à transistor selon la présente invention est que la faible résistance dynamique du résonateur permet de réaliser des oscillateurs ayant une basse consommation.

### Brèves description des figures

D'autres caractéristiques et avantages de la présente invention apparaîtront à la lecture de la description qui va suivre, donnée uniquement à titre d'exemple non limitatif, et faite en référence aux dessins annexés dans lesquels :
- la figure 1 est le schéma d'un accéléromètre de l'art antérieur, comportant un transistor à grille mécanique ;
- la figure 2 est une vue schématique en plan d'un résonateur à transistor selon un premier mode de réalisation de la présente invention ; la figure montre aussi deux films piézoélectriques prévus pour exciter le résonateur ;
- les figures 3A et 3B sont des vues schématiques en coupe du résonateur de la figure 2, respectivement selon A-A et B-B **;**
- la figure 4 est un schéma de principe montrant les déformations selon un mode de vibration particulier du résonateur du transistor des figures 2 et 3 ;
- la figure 5 est une vue schématique en plan d'un résonateur à transistor selon une variante du mode de réalisation représenté dans la figure 2 ;
- les figures 6A à 6H illustrent différentes étapes d'un procédé de fabrication permettant de réaliser le résonateur à transistor représenté dans les figures 2 et 3 ;
- la figure 7A est une vue en perspective d'un résonateur à transistor selon un deuxième mode de réalisation de la présente invention ;
- la figure 7B est un schéma en perspective montrant les déformations selon un mode de vibration particulier du résonateur de la figure 7A ;
- La figure 7C est une vue schématique en perspective montrant la microstructure en un matériau piézoélectrique prévue pour assurer un couplage électromécanique entre le résonateur micromécanique et le canal du transistor de la figure 7A.

### Description détaillée de modes de réalisation exemplaires

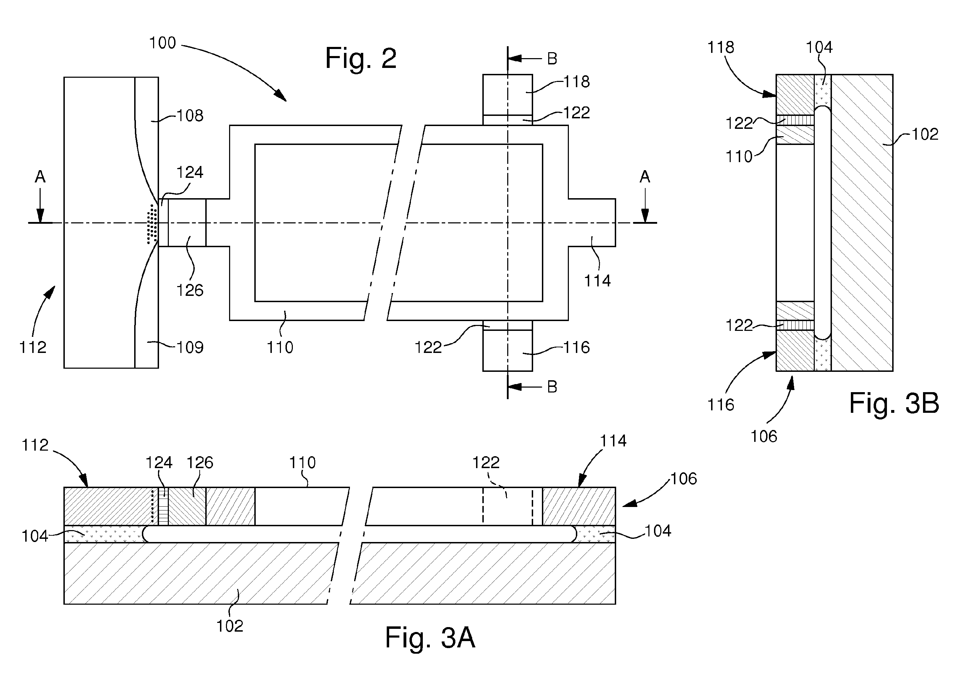

Les figures 2, 3A, 3B et 4 illustrent un oscillateur MEMS qui correspond à un premier mode de réalisation de la présente invention. Certains composants de l'oscillateur qui ne concernent pas directement la présente invention ont été omis pour ne pas surcharger les figures. L'oscillateur MEMS du présent exemple est basé sur un résonateur à transistor selon l'invention. Le résonateur 100 est entièrement réalisé par gravure dans une plaquette en matériau cristallin ou amorphe, tel que du silicium. Comme on peut s'en rendre compte à partir de figures 3A et 3B, en particulier, une particularité de ce premier mode de réalisation est que le résonateur et son transistor sont formés dans un même plan parallèle à la plaquette.

Dans le présent exemple, la plaquette est du type Silicon On Insulator (SOI) et comprend un substrat épais 102 en silicium, une couche intermédiaire 104 d'oxyde de silicium isolant, et une couche supérieure 106 en silicium dans laquelle est gravé le résonateur. En se référant plus particulièrement à la figure 2, on peut voir que le résonateur du présent exemple est principalement formé d'un cadre résonnant 110 soutenu à ses deux extrémités par des supports 112 et 114. Comme on peut le voir sur la figure 3A, le support 114 est formé d'un pied en dioxyde de silicium surmonté d'un bras en silicium qui vient de matière avec le cadre résonant 110. Le support 112 comporte également un pied en dioxyde de silicium. Toutefois, contrairement au support 114, le support 112 n'est pas en contact direct avec le cadre 110. En effet, comme le montre les figures, une microstructure 126 en un matériau piézoélectrique et une couche d'oxyde isolant 124 sont intercalées entre le support 112 et le cadre 110 (dans le présent exemple, la microstructure 126 peut simplement consister en une épaisseur de matériau piézoélectrique).

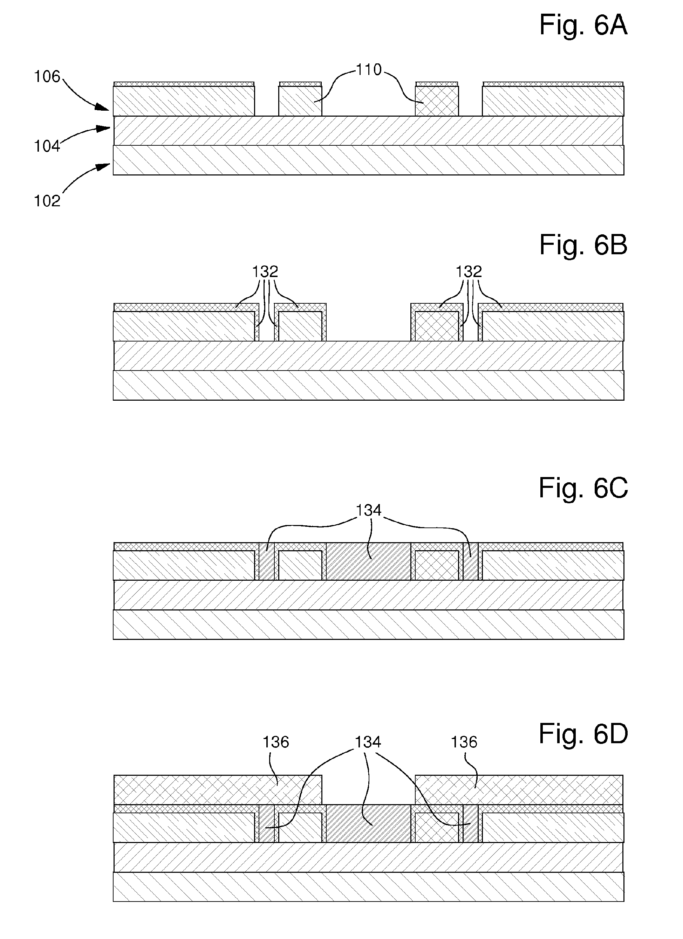

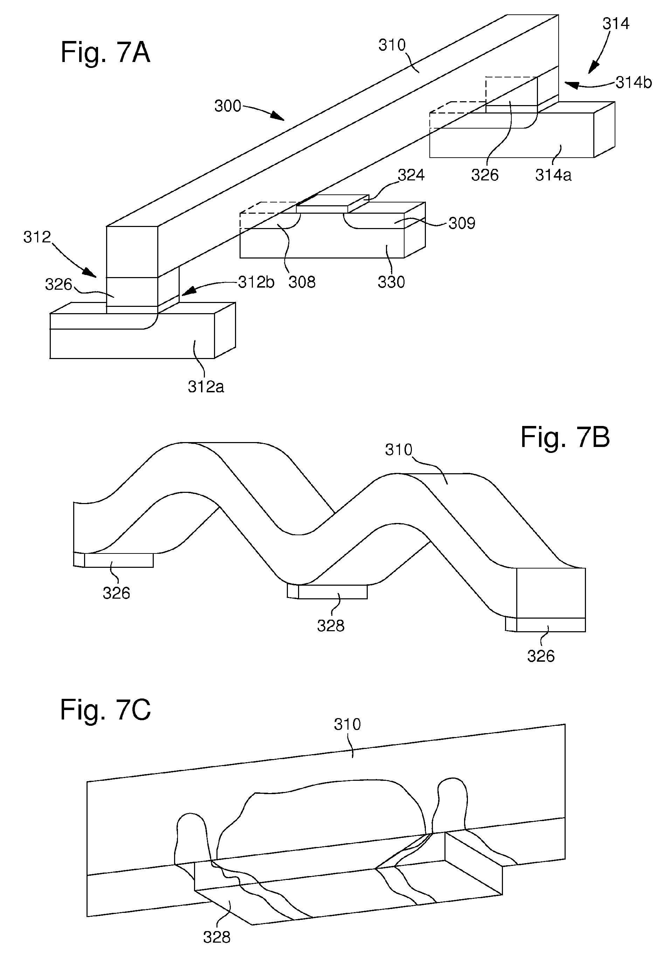

La partie supérieure en silicium du support 114 constitue un caisson semi-conducteur de type-p pour un transistor. Un élément de conduction du transistor constitué par une région de source 108, une région de drain 109, et une région dopée n (non référencée) formant un canal pour relier la région de source et la région de drain est formée dans le caisson. La couche d'oxyde isolant 124, déjà mentionnée, recouvre la région de canal de l'élément de conduction, et l'épaisseur de matériau piézoélectrique 126 est intercalée entre la couche d'oxyde 124 et le cadre 110. L'empilement horizontal formé par la couche d'oxyde 124 et l'épaisseur de matériau piézoélectrique 126 constitue ce qu'on appelle un « empilement de grille » (ou « gate stack » en anglais). Selon des variantes de l'invention, la structure de l'empilement de grille peut être plus complexe que celle qui vient d'être décrite. Tout d'abord, il peut être avantageux de former une couche de dioxyde de silicium de part et d'autre du matériau piézoélectrique (Cette variante correspond à la structure illustrée dans la série de figures 6A à 6H). D'autre part, l'épaisseur de matériau piézoélectrique peut par exemple être prise en sandwich entre deux couches d'un matériau à constante diélectrique élevée, de manière à améliorer le couplage électromécanique. Finalement, on peut prévoir, comme c'est d'ailleurs le cas avec le mode de réalisation illustré à la figure 7, que l'empilement de grille comprenne un gap, c'est-à-dire un espace vide séparant deux couches successives de l'empilement. Précisons encore que, comme on l'a déjà dit, dans le présent exemple, le silicium formant le support 112 a reçu un dopage de type-p, et la source 108 et le drain 109 sont des régions qui ont ensuite été dopées n. Toutefois, l'invention ne se limite évidemment pas à cette variante.

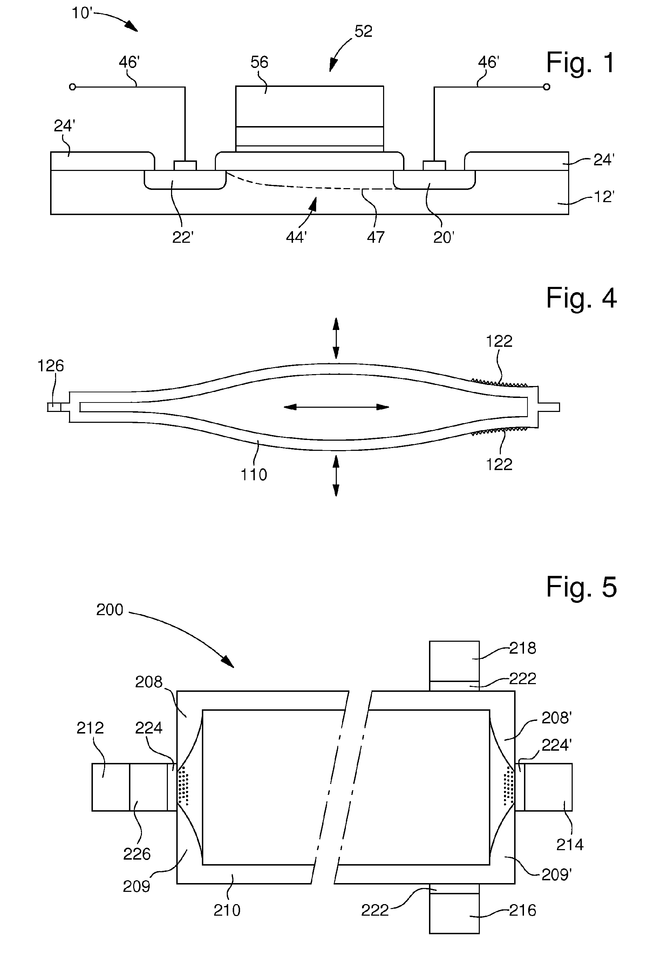

Comme le montre encore la figure 2, le résonateur à essentiellement la forme d'un cadre rectangulaire 110 maintenu en place par ses deux petits côtés qui sont reliés aux supports 112 et 114. Les grands côtés du cadre sont libres de se déformer. En comparant la figure 2 avec la figure 4 qui représente le même résonateur, on peut se rendre compte que le cadre 110 a une forme très allongée, et qu'il a été amputé de sa portion centrale sur les figures 2 et 3A. D'un point de vue fonctionnel, le résonateur de la figure 2 peut être assimilé à un résonateur à diapason qui serait fermé à ses deux extrémités ou, mieux encore, à une paire de diapasons placés bout à bout et dont les bras se rejoindraient. La figure 4 illustre les déformations subies par le cadre 110 dans un mode de vibration particulier. On comprendra que dans le mode de vibration représenté, les deux bras du résonateur sont toujours symétriques, ce qui a pour avantage d'éviter tout déplacement du centre de gravité de la structure transversalement à son axe longitudinal. On comprendra toutefois que la présente invention ne se limite pas à un mode de vibration particulier. De plus, la présente invention ne se limite pas non plus au type particulier de résonateur qui est décrit dans le présent exemple.

En se référant maintenant à la figure 3B, on peut voir qu'en plus des deux supports 112, 114, le cadre résonant 110 est également en appui sur deux structures 116, 118. Comme les supports 112, 114, les deux structures 116, 118 sont chacune formées d'un pied en dioxyde de silicium et d'un bras en silicium. Comme le montre la figure 2, les bras des supports 116, 118 sont chacun reliés à un des grands côtés du cadre 110. On voit de plus qu'une épaisseur de matériau piézoélectrique 122 est intercalée entre chacun des bras et le côté correspondant du cadre 110. Les structures 116, 118 sont prévues pour faire vibrer les deux grands côtés du cadre 110 grâce à l'effet piézoélectrique. A cet effet, les deux structures 116, 118 reçoivent un signal d'excitation dont la fonction est de faire alternativement se dilater et se contracter les épaisseurs de matériau 122 par effet piézoélectrique inverse. L'amplitude de la variation d'épaisseur du matériau piézoélectrique étant très limitée, les structures 116 et 118 sont de préférence placées pratiquement à une extrémité des grands côtés du cadre 110, proche du support 114. On comprendra que cet arrangement permet de mettre à profit un effet de bras de levier.

Lorsque le cadre 110 vibre sous l'effet du signal d'excitation, le degré de courbure des grands côtés varie symétriquement. On comprendra que la résultante de cette variation symétrique est de faire alternativement s'allonger et se raccourcir le cadre 110. Comme le montre la figure 2, une des extrémités du cadre 110 est maintenue fixe par l'action conjuguée du support 114 et des deux structures 116, 118. Dans ces conditions, tout changement dans la longueur du cadre 110 va se répercuter au niveau du support 112. C'est l'épaisseur de matériau piézoélectrique 126 qui va absorber les variations de longueur du cadre 110 en se déformant. Le matériau piézoélectrique 126 va être alternativement étiré et comprimé, ce qui a pour effet de le faire se polariser cycliquement. Finalement, de manière connue en soi, la conductivité du canal reliant la région de source 108 à la région de drain 109 sera modulée en fonction du degré de polarisation du matériau piézoélectrique 126.

Comme on l'a dit plus haut, certains composants qui font habituellement partie d'un oscillateur ne figurent pas sur les dessins et n'ont pas été décrits. Parmi ces composants, on peut citer en particulier un circuit d'alimentation pour établir une polarisation entre la région de source 108 et la région de drain 109, et un circuit de rétroaction pour fournir un signal d'excitation au structure 116 et 118 en réponse à un courant électrique entre la région de source 108 et la région de drain 109. Les circuits qui viennent d'être mentionnés n'ont pas été décrits en détail car leur réalisation peut être tout à fait classique, et ne nécessite pas d'explications pour l'homme du métier. Par ailleurs, le résonateur selon l'invention comporte évidemment des plages ou des plots de connexion (non représentés) pour connecter l'oscillateur avec l'extérieur, ainsi que des pistes pour relier électriquement les différents composants de l'oscillateur entre eux. Les pistes (non représentées) peuvent par exemple être formée proche de la surface de la couche de silicium supérieure 106 par dopage du silicium. Alternativement, les pistes peuvent être formées par des métallisations déposées sur le silicium.

D'autre part, selon une variante avantageuse du présent exemple, l'oscillateur MEMS peut encore comprendre des moyens pour imposer une tension de décalage permettant de centrer, sur le point de fonctionnement du canal, l'intervalle à l'intérieur duquel varie la tension de polarisation du matériau piézoélectrique. A cet effet, le cadre 110 et le support 114 peuvent être rendus conducteurs par un dopage approprié. Ainsi, en connectant le support 114 à une source de tension, il est possible d'ajuster la tension de polarisation du cadre 110. L'épaisseur de matériau piézoélectrique étant solidaire du cadre, la tension de polarisation du cadre constitue un potentiel de référence autour duquel oscille la polarisation du matériau piézoélectrique.

La figure 5 représente un oscillateur MEMS 200 selon l'invention. Cet oscillateur correspond à une variante du mode de réalisation décrit en relation avec les figures 2 à 4. Comme dans l'exemple précédent, le résonateur 200 est entièrement réalisé par gravure dans une plaquette de silicium, et le résonateur et sont transistor sont formés dans un même plan parallèle à la plaquette. Le résonateur comporte un cadre résonnant 210 soutenu à ses deux extrémités par des supports 212 et 214. Ces supports sont chacun constitués d'un pied en dioxyde de silicium surmonté d'un bras en silicium. Les supports 212, 214 ne sont pas en contact direct avec le cadre 210. En effet on peut voir d'une part, sur la figure 5, qu'une couche d'oxyde isolant 224' est intercalée entre le cadre 210 et le support 214, et d'autre part, qu'une épaisseur de matériau piézoélectrique 226 et une couche d'oxyde isolant 224 sont intercalées entre le cadre et le support 212.

Les deux petits côtés du cadre 210 constituent chacun un caisson semi-conducteur de type-p pour un transistor à effet de champ. Ces transistors comportent chacun un élément de conduction constitué par une région de source (référencées respectivement 208, 208'), une région de drain (référencées respectivement 209, 209') et une région dopée n (non référencées) formant un canal pour relier la région de source et la région de drain. Les couches d'oxyde isolant (référencées respectivement 224, 224') recouvrent la région de canal de chaque transistor. A l'instar de ce qui était le cas dans l'exemple précédent, le silicium formant les petits côtés du cadre 210 peut par exemple avoir reçu un dopage de type-p, et les régions de source 208, 208' et de drain 209, 209' avoir été dopées n. Le support 214 fait office de grille pour l'un des transistors, alors que l'épaisseur de matériau piézoélectrique 226 intercalée entre le cadre 210 et le support 212 jour le rôle de grille pour l'autre transistor. Le transistor à effet de champ associé au support 214 peut être inactif, jouant simplement le rôle de résistance variable commandée en fonction de la polarisation du support 214.

De façon semblable à ce qui était le cas pour l'oscillateur du premier exemple, deux structures 216, 218 sont prévues pour faire vibrer les deux grands côtés du cadre 210. A cet effet, les deux structures 216, 218 reçoivent un signal d'excitation dont la fonction est de faire alternativement se dilater et se contracter les épaisseurs de matériau 222 par effet piézoélectrique inverse. Conformément à ce qui a déjà été expliqué dans le cadre du premier exemple, la vibration du cadre 210 s'accompagne d'une variation cyclique de sa longueur, l'épaisseur de matériau diélectrique 226 est donc alternativement étirée et comprimée, provoquant une polarisation cyclique de la grille du transistor.

Les figures 6A à 6H sont des vues en coupe qui illustrent, à titre d'exemple uniquement, les principales étapes d'un procédé de fabrication permettant de réaliser le résonateur 100 représenté dans les figures 2, 3 et 4, et permettant de réaliser, notamment, l'épaisseur de matériau piézoélectrique 126 (figure 2).

Comme déjà mentionné, le résonateur 100 peut être entièrement réalisé par gravure dans une plaquette du type Silicon On Insulator (SOI). La plaquette comprend un substrat épais 102 en silicium, une couche intermédiaire 104 d'oxyde de silicium isolant, et une couche supérieure 106 en silicium dans laquelle sont formés les composants de l'oscillateur MEMS selon l'invention et notamment le résonateur 100. La structure du résonateur peut tout d'abord être gravée dans la couche supérieure 106 en silicium pour arriver au résultat illustré par la figure 6A. L'homme du métier pourra réaliser la gravure par tout moyen qui lui paraîtra adéquat. D'autre part, bien que la figure 6A ne les montre pas, c'est préférablement durant cette première étape que sont réalisés les plots ou plages de connexion et les pistes conductrices servant à relier les composants de l'oscillateur entre eux. Comme déjà mentionné, les pistes peuvent par exemple être formée par un dopage superficiel du silicium. Alternativement, les pistes peuvent par exemple être formées par des métallisations déposées sur le silicium.

Comme représenté à la figure 6B, une couche de diélectrique 132 est ensuite formée sur le silicium, y compris sur les parois verticales. Le diélectrique 132 est prévu notamment pour constituer le diélectrique de grille 124 (figure 2). La couche de diélectrique 132 peut être par exemple du dioxyde de silicium formé par oxydation thermique du silicium. Cet oxyde peut être ensuite éliminé localement aux emplacements où il n'est pas utile. Le dioxyde de silicium n'est qu'une possibilité parmi d'autre pour réaliser la couche de diélectrique 132. Le SiO₂ peut être remplacé ou combiné à d'autre matériau diélectrique pour, d'une part, améliorer la constante diélectrique, et d'autre part, améliorer la sélectivité lors de la gravure.

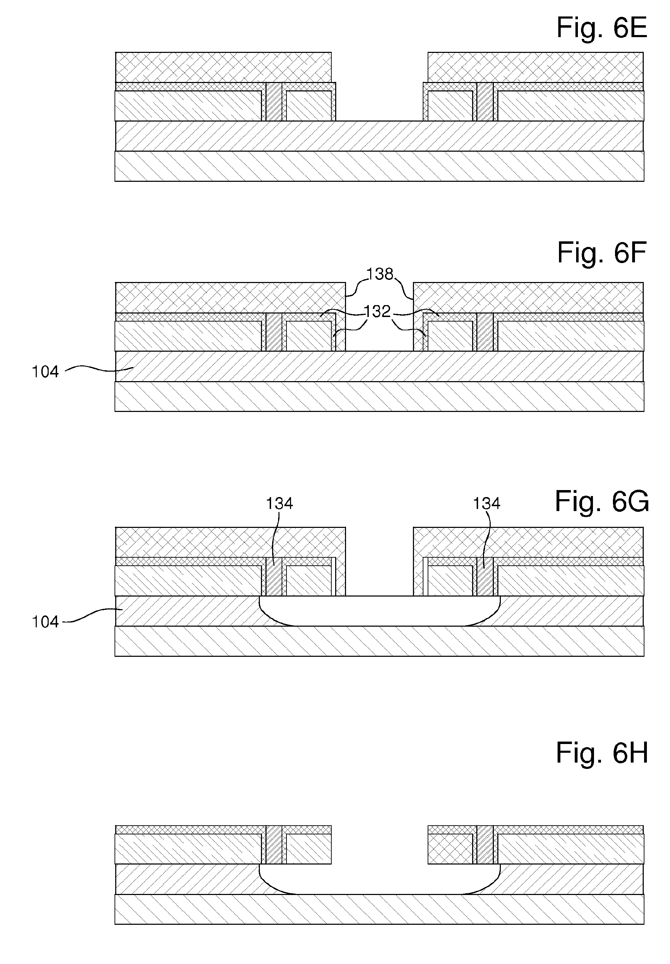

Comme représenté à la figure 6C, on fait ensuite croître un matériau diélectrique 134 dans les ouvertures préalablement gravée dans la couche supérieur de silicium 106. La surface de la plaquette est ensuite configurée à l'aide d'une résine photosensible 136 comme illustré par la figure 6D. La couche de résine photosensible est prévue pour protéger le matériau piézoélectrique 134 aux emplacements où il est utile. Le reste du matériau piézoélectrique 134 est éliminé par attaque chimique pour arriver au résultat illustré à la figure 6E.

Un nouveau masque de gravage 138 est ensuite formé de manière à protéger la couche de diélectrique 132 qui recouvre les parois verticales (figure 6F). La plaquette SOI gravée est ensuite immergée dans un bain pour dissoudre le dioxyde de silicium 104 exposé, de façon à libérer partiellement le silicium et le matériau piézoélectrique 134. Un temps d'exposition idéal ayant préalablement été déterminé grâce à quelques essais, le résultat de l'étape de dissolution du dioxyde de silicium donne le résultat illustré à la figure 6G. Finalement, la résine 136, 138 est éliminée pour arriver au résultat illustré à la figure 6H.

Les figures 7A, 7B et 7C sont des vues un perspectives d'un deuxième mode de réalisation du résonateur à transistor 300 selon l'invention. Contrairement aux résonateurs 100 et 200 des précédents exemples, le résonateur 300 est prévu pour s'étendre de préférence dans un plan vertical (perpendiculaire à un substrat).

En se référant plus particulièrement à la figure 7A, on peut voir que le résonateur 300 est principalement formé d'une poutre vibrante 310 soutenue à ses deux extrémités par des supports 312 et 314. Les supports 312, 314 comportent chacun un pied 312a, 314a en silicium dopé surmonté d'une superstructure 312b, 314b. Chacune des superstructures 312b, 314b comprend une épaisseur de matériau piézoélectrique 326. Les deux parties 326 en matériau piézoélectrique sont prévues pour faire vibre la poutre 310 selon un mode de vibration particulier. A cet effet, les deux parties 326 reçoivent un signal d'excitation dont la fonction est de faire alternativement se dilater et se contracter chacune des deux épaisseurs de matériau piézoélectrique. L'amplitude de la variation d'épaisseur du matériau piézoélectrique étant très limitée, les deux parties 326 sont de préférence placées pratiquement aux extrémités de la poutre 310.

Comme le montre les figures 7B et 7C, le résonateur à transistor 300 comprend encore un élément piézoélectrique de détection 328 qui est arrangé au centre de la poutre 310. L'élément piézoélectrique de détection 328 a une forme sensiblement plane et il est solidaire de la surface inférieure de la poutre 310. La poutre vibrante est prévue pour être excitée à la première harmonique de sa fréquence fondamentale. Dans ces conditions, conformément à ce qui représenté à la figure 7B, l'onde stationnaire produite par les vibrations de la poutre possède deux ventres séparés par un noeud au centre de la poutre. Ainsi, lorsque la poutre vibre, sa partie centrale se courbe sensiblement, mais, en principe, ne se déplace pas. Ainsi, l'élément piézoélectrique 328 solidaire du centre de la poutre est soumis à des contraintes d'étirement importantes, tout en demeurant pratiquement immobile.

On voit encore sur la figure 7A qu'un caisson semi-conducteur 330 est arrangé sous la poutre 310, en regard de l'élément piézoélectrique de détection 328. Une région de source 308 et une région de drain 309, ainsi qu'une structure de canal (non référencée) située entre la région de source et la région de drain, sont formées dans le caisson 330. On voit encore sur la figure 7A qu'une couche d'oxyde de silicium isolant 324 recouvre la structure de canal qui relie la région de source 308 à la région de drain 309. La couche d'oxyde 324 fait face à l'élément piézoélectrique de détection 328, ces deux éléments n'étant pas en contact direct, mais séparé par un petit espace (ou « gap » en anglais).

La figure 7C illustre de manière schématique la polarisation de l'élément piézoélectrique de détection 328 lorsqu'il est déformé par la vibration de la poutre 310. Lorsque le milieu de la poutre passe par des phases successives de fléchissement et se redressement, l'élément piézoélectrique 328 se polarise et se dépolarise en alternance. L'espace entre l'élément piézoélectrique et le caisson 330 étant très étroit, la conductivité du canal reliant la région de source 308 à la région de drain 309 est modulée par le champ électrique cyclique associé à la polarisation de l'élément piézoélectrique 328.

Comme c'était déjà le cas avec le premier mode de réalisation, certains éléments faisant habituellement partie d'un oscillateur ne figurent pas sur les dessins et n'ont pas été décrits. Parmi ces composants, on peut citer en particulier un circuit d'alimentation pour établir une polarisation entre la région de source 308 et la région de drain 309, et un circuit de rétroaction pour fournir un signal d'excitation aux parties 326 en réponse à un courant électrique à travers la structure de canal reliant la région de source 308 et la région de drain 309. Comme dans l'exemple précédent, la réalisation des composants non décrits peut être tout à fait classique, et ne nécessite pas d'explications pour l'homme du métier.

On comprendra en outre que diverses modifications et/ou améliorations évidentes pour un homme du métier peuvent être apportées aux modes de réalisation qui font l'objet de la présente description sans sortir du cadre de la présente invention définie par les revendications annexées. II n'est notamment pas nécessaire d'utiliser des moyens piézoélectriques pour actionner la structure vibrante du résonateur selon l'invention. Les moyens piézoélectriques décrits ci-dessus, 122 (figures 2, 3A et 3B), 222 (figures 5) et 326 (figure 7A et 7B), pourraient par exemple être remplacés de manière connue en soi par des moyens capacitifs.

## Revendications

1. Résonateur MEMS à transistor comprenant :
- un caisson dans lequel est formé un élément de conduction constitué par une région de source (108 ; 208 ; 308), une région de drain (109 ; 209 ; 309), et une région semi-conductrice formant un canal reliant la région de source et la région de drain ;
- une structure vibrante (110 ; 210 ; 310) solidaire d'un substrat tout en étant libre de vibrer ;
- une structure fixe (112 ; 212 ; 330) portée par le substrat, un espace (ou gap) étant aménagé entre la structure fixe et la structure vibrante ;
le caisson étant intégré soit dans la structure vibrante (210), soit dans la structure fixe (112 ; 330), de telle façon que le canal s'étende en regard du dit espace ;
**caractérisé en ce que** ledit espace renferme une microstructure (126 ; 226 ; 328) en un matériau piézoélectrique prévue pour assurer un couplage électromécanique entre la structure vibrante (110 ; 210 ; 310) et le canal de manière à permettre de moduler la conductibilité de l'élément de conduction à la fréquence de vibration de la structure vibrante.

2. Résonateur MEMS à transistor selon la revendication 1, **caractérisé en ce que** le caisson est intégré dans la structure fixe. (112 ; 330)

3. Résonateur MEMS à transistor selon la revendication 2, **caractérisé en ce que** la microstructure (328) en un matériau piézoélectrique est solidaire de la structure vibrante (310) et qu'elle est séparée du dit canal par un espace dégagé.

4. Résonateur MEMS à transistor selon la revendication 2, **caractérisé en ce que** la microstructure (126) en un matériau piézoélectrique est solidaire à la fois de la structure vibrante (110) et du caisson (112).

5. Résonateur MEMS à transistor selon la revendication 1, caractérisé en ce le caisson est intégré dans la structure vibrante (210).

6. Résonateur MEMS à transistor selon la revendication 5, **caractérisé en ce que** la microstructure (226) en un matériau piézoélectrique est solidaire à la fois de la structure fixe (212) et du caisson.

7. Résonateur MEMS à transistor selon l'une des revendications précédentes, **caractérisé en ce que** la microstructure (126 ; 226 ; 328) en un matériau piézoélectrique est solidaire d'une partie conductrice (110 ; 212 ; 310) du résonateur, ladite partie conductrice étant reliée à une source de tension de manière à permette d'ajuster un potentiel de référence pour la structure en un matériau piézoélectrique.

8. Résonateur MEMS à transistor selon l'une des revendications précédentes, **caractérisé en ce qu**'un plan principal du résonateur, qui passe par la région de source (108 ; 208), la région de drain (109 ; 209), le canal, la microstructure en un matériau piézoélectrique (126 ; 226) et la structure vibrante (110 ; 210), est parallèle au substrat (102).

9. Résonateur MEMS à transistor selon l'une des revendications 1 à 7, **caractérisé en ce qu**'un plan principal du résonateur, qui passe par la région de source (308), la région de drain (309), le canal, la microstructure en un matériau piézoélectrique (328) et la structure vibrante (310), est perpendiculaire au substrat.

10. Résonateur MEMS à transistor selon l'une des revendications précédentes, **caractérisé en ce qu**'au moins une partie en matériau piézoélectrique (122 ; 222 ; 326) est fixée à la structure vibrante (110 ; 210 ; 310) de manière à permettre à un signal d'excitation de faire vibrer la structure vibrante.

11. Oscillateur MEMS comprenant:
- un caisson (112 ; 230) dans lequel est formé un élément de conduction constitué par une région de source (108 ; 208 ; 308), une région de drain (109 ; 209 ; 309), et une région semi-conductrice formant un canal reliant la région de source et la région de drain ;
- une alimentation arrangée pour établir une polarisation entre la région de source et la région de drain ;
- une structure vibrante (110 ; 210 ; 310) solidaire d'un substrat tout en étant libre de vibrer ;
- un circuit de rétroaction prévu pour fournir signal d'excitation à la structure vibrante en réponse à un courant électrique à travers l'élément de conduction ;
- une structure fixe (112 ; 212 ; 330) portée par le substrat, un espace (ou gap) étant aménagé entre la structure fixe et la structure vibrante ;
le caisson étant intégré soit dans la structure vibrante (210), soit dans la structure fixe (112 ; 330), de telle façon que le canal s'étende en regard du dit espace ;
**caractérisé en ce que** ledit espace renferme une microstructure (126 ; 226 ; 328) en un matériau piézoélectrique prévue pour assurer un couplage électromécanique entre la structure vibrante (110 ; 210 ; 310) et le canal de manière à permettre de moduler la conductibilité de l'élément de conduction à la fréquence de vibration de la structure vibrante.
